# FASCICULE DE BREVET EUROPEEN

(11) **EP 0 501 366 B1**
(45) Date de publication et mention de la délivrance du brevet: **13.04.1994**
(21) Numéro de dépôt: 92103045.8
(22) Date de dépôt: 24.02.1992
(51) Int. Cl.: H03J 7/06

(54) **Dispositif de transposition de fréquence avec commande automatique de fréquence**
Anordnung zur Frequenzumsetzung mit automatischer Frequenzabstimmung
Frequency translating arrangement with automatic frequency control

(30) Priorité: 28.02.1991 FR 9102415
(43) Date de publication de la demande: 02.09.1992
(73) Titulaire: ALCATEL TELSPACE, 92734 Nanterre Cédex (FR)
(72) Inventeur: Doncker, Jacques, F-95450 Vigny (FR); Leclerc, Gérard, F-95520 Osny (FR)
(74) Mandataire: Weinmiller, Jürgen

(56) Documents cités:
- PATENT ABSTRACTS OF JAPAN vol. 5, no. 19 (E-044)4 Février 1981
- PATENT ABSTRACTS OF JAPAN vol. 6, no. 222 (E-140)(1100) 6 Novembre 1982
- PATENT ABSTRACTS OF JAPAN vol. 7, no. 272 (E-214)(1417) 3 Décembre 1983
- PATENT ABSTRACTS OF JAPAN vol. 7, no. 36 (E-158)(1181) 15 Février 1983

## Description

La présente invention se rapporte à un dispositif de transposition de fréquence, typiquement de transposition en Fréquence Intermédiaire, ce dispositif étant équipé d'une Commande Automatique de Fréquence ou "C.A.F." et étant par exemple apte à équiper un récepteur de télévision par satellite.

Une installation de réception de télévision par satellite est actuellement constituée de deux équipements radiofréquence essentiels:
- Une tête de réception dans laquelle le signal hyperfréquence capté par l'antenne est transposé en un signal de plus faible fréquence compris dans une bande de fréquences actuellement normalisée, dite "Bande Intermédiaire Satellite" ou "B.I.S.", comprenant les fréquences de canal entre 950 et 1750 Mégahertz.
- Un récepteur proprement dit, qui reçoit ce signal en B.I.S. et, après transposition en Fréquence Intermédiaire, le démodule pour en extraire les signaux utiles, vidéo et son.

Pour des raisons de prix de revient, les oscillateurs locaux qui équipent les têtes de réception précitées du signal hyperfréquence sont réalisés sans grande stabilité en fréquence. On utilise en effet ici des oscillateurs dits libres (par opposition aux oscillateurs qui sont par exemple verrouillés sur des quartz), en général à résonateurs diélectriques, dont la dérive, pour une fréquence d'oscillation de l'ordre de 10 Gigahertz, est généralement de l'ordre de 2 à 3 Mégahertz en température et dans le temps. En l'absence de toute Commande Automatique de Fréquence, on retrouve alors, à l'entrée du démodulateur qui équipe le récepteur précité, une dérive correspondante de la fréquence porteuse centrale: cette fréquence centrale n'est alors plus centrée sur la fréquence médiane de la bande qui correspond à celle du filtre de bande classiquement utilisé en Fréquence Intermédiaire.

Si cet inconvénient peut à la rigueur être toléré sur certaines installations domestiques, il ne peut pas l'être pour les stations d'un réseau de distribution de télévision par satellite.

Une solution pour éviter cet effet dommageable sans modification onéreuse de la tête de réception hyperfréquence consiste à équiper le récepteur qui reçoit le signal en B.I.S. d'un dispositif de Commande Automatique de Fréquence (C.A.F.) qui fait automatiquement varier la fréquence de l'Oscillateur Local du dispositif de transposition en Fréquence Intermédiaire de façon qu'en dépit des fluctuation de la fréquence B.I.S. reçue, la Fréquence Intermédiaire de sortie, qui est égale à la différence de ces deux fréquences, reste constante. Il suffit donc pour ceci que cette fréquence d'Oscillateur Local varie constammant, sous commande du C.A.F., dans le même sens et des mêmes valeurs que cette fréquence B.I.S. d'entrée, voir par exemple le document PATENT ABSTRACTS OF JAPAN, vol.5, no.19 (E-044) 4 Février 1981 & JP-A-55 147 823 (FUJITSU TEN LTD) 18 Novembre 1980.

Les performances généralement requises dans ce but sont un rattrapage de Fréquence Intermédiaire FI de plus ou moins 30 Kilohertz pour une dérive de la fréquence de signal en B.I.S. de plus ou moins 3 Mégahertz dans une gamme de températures de -10°C à +50°C.

Il existe des dispositifs de C.A.F. utilisés dans ce but, et pour lesquels la tension d'erreur qui commande l'organe de rattrapage de fréquence est issue soit d'un discriminateur de fréquences, soit d'un détecteur de phases. Tous ces dispositifs connus ont pour inconvénients d'avoir des caractéristiques de transfert sensibles aux variations de température et difficilement maîtrisables.

A noter qu'une compensation de fréquence par variation de la fréquence de référence d'un synthétiseur constituant l'Oscillateur Local est difficilement concevable, car la fréquence d'un synthétiseur utilisant une boucle à verrouillage de phase avec diviseur agile de rang N variable est liée à sa fréquence de référence par un facteur de proportionnalité qui dépend de ce rang N, de sorte que la compensation de fréquence alors obtenue varierait suivant la fréquence du canal reçu.

La Demanderesse a envisagé de contourner toutes ces difficultés en réalisant un asservissement en fréquence de l'Oscillateur Local du récepteur en B.I.S., réalisé sous forme de synthétiseur comportant un quartz pour la fixation de sa fréquence de référence et une boucle à verrouillage de phase, sur le signal en B.I.S. reçu en réalisant une soustraction des fréquences de ce signal reçu et de l'Oscillateur Local, et en introduisant l'erreur de fréquence qui en résulte dans la boucle d'asservissement en phase de cet Oscillateur Local.

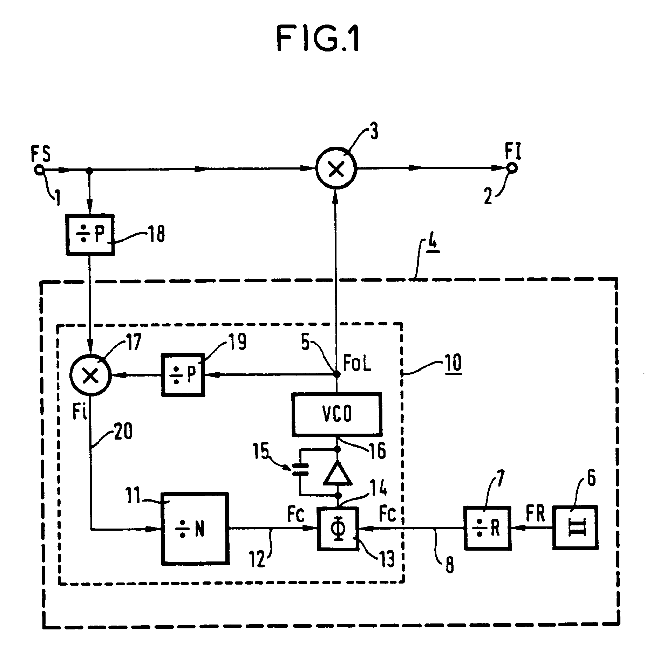

Le schéma synoptique d'un tel dispositif est réprésenté sur la Figure 1 jointe, qui représente le dispositif de transposition en Fréquence Intermédiaire de valeur fixe FI.

Sur cette Figure, la Fréquence reçue FS en B.I.S. est appliquée sur la borne d'entrée 1 du dispositif de transposition de fréquence, tandis que la Fréquence Intermédiaire FI, qui est prélevée sur sa borne de sortie 2, est classiquement obtenue par soustraction, dans un mélangeur 3, du signal précité à fréquence FS et de celui, à fréquence FOL de l'Oscillateur Local 4, qui est appliqué sur l'autre entrée 5 de ce circuit 3.

Basiquement, cet Oscillateur Local 4 est composé d'un synthétiseur de fréquences à boucle à verrouillage de phase, en soi très classique, et comportant donc:
- Un oscillateur à quartz 6, de fréquence FR rigoureusement fixe, suivi d'un diviseur de fréquence 7 de rang R, fournissant sur sa sortie 8 la fréquence de référence Fc du synthétiseur 4.
- Un Oscillateur Commandé en Tension ou "VCO" 9 qui fournit sur sa sortie 5 la fréquence FOL d'Oscillateur Local.
- Une boucle de phase 10, comportant entre autres au moins un diviseur de fréquences 11 de rang N dont le signal de sortie est appliqué à une des deux entrées 12 d'un comparateur de phases 13 dont l'autre entrée est constituée par la sortie 8 précitée du diviseur 7. Le signal d'erreur en sortie 14 de ce comparateur de phases 13 est classiquement appliqué, via un circuit d'amplification et de filtrage 15, sur la borne de commande 16 du VCO 9.

Conformément à la proposition précitée de la Demanderesse, il est créé, par soustraction des fréquences incidente FS et d'Oscillateur Local FOL, un signal d'erreur qui est introduit dans la boucle de phase 10. On utilise pour ceci un soustracteur de fréquences 17 qui reçoit, via des diviseurs de fréquence respectifs 18 et 19 de même rang P, d'une part une portion du signal d'entrée à fréquence FS, et d'autre part la portion du signal d'oscillateur local FOL qui est introduite dans la boucle 10. Le signal différentiel qui en résulte en sortie 20 de ce circuit 17 est appliqué au diviseur 11 de rang N précité.

A noter que les diviseurs 18 et 19, à priori facultatifs, permettent avantageusement de minimiser l'influence de la modulation portée par le signal incident à fréquence FS, ainsi que de travailler à des fréquences plus faibles, ce qui permet de diviser l'effet du bruit porté dans la bande.

Le fonctionnement de ce dispositif se comprend aisément par le fait connu que la boucle de phase 10 agit d'elle-même pour annuler toute dérive de fréquence du VCO 9. Si donc une dérive extérieure est introduite par le circuit 17 dans cette même boucle, ce même asservissement agit sur la fréquence du VCO 9 pour annuler cette dérive, de sorte que finalement la fréquence FOL sera incrémentée ou décrémentée de la valeur de cette dérive, ce qui est bien l'effet recherché pour un C.A.F., puisque justement cette dernière correspond à la dérive parasite en fréquence du signal en B.I.S.

Le circuit selon cette figure 1 présente néanmoins un très gros inconvénient, qui le rend en pratique inutilisable sauf pour des applications particulières: comme par définition la fréquence FI, qui est égale à la différence des fréquences FS et FOL, est constante, il s'ensuit que la fréquence différentielle Fi en sortie 20 du soustracteur 17 est elle-aussi constante, et qu'en conséquence il est impossible de faire varier le rang N du diviseur 11, de sorte que finalement ce récepteur ne peut fonctionner que pour un seul canal, à fréquence FS déterminée.

L'invention vise à remédier aux inconvénients précités de ces dispositifs connus. Elle se rapporte à cet effet à un dispositif de transposition de fréquence d'un signal d'entrée de fréquence FS, typiquement de transposition en Fréquence Intermédiaire, ce dispositif comportant un Oscillateur Local constitué par un premier synthétiseur asservi sur une fréquence de référence Fc par une boucle à verrouillage de phase comportant un diviseur de rang N, des moyens étant prévus pour introduire dans la boucle de phase de ce synthétiseur un signal différentiel Fi dont la fréquence est proportionelle à la différence des fréquences incidente FS et d'Oscillateur Local FOL de manière à réaliser ainsi une Commande Automatique de Fréquence, ce dispositif se caractérisant en outre par le fait que, afin de pouvoir utiliser un diviseur de rang N variable par unités pour pouvoir traiter plusieurs fréquences d'entrée différentes, il est en outre prévu d'intercaler dans cette boucle de phase, entre le point d'introduction dans cette boucle dudit signal différentiel Fi et ce diviseur de rang N, un dispositif apte à réaliser l'addition en fréquences de ce signal différentiel Fi et d'un autre signal de fréquence Fo qui est élaboré par un autre synthétiseur comportant une autre boucle à verrouillage de phase à diviseur de rang M, ce dernier variant et à chaque fois dans le même sens que l'autre diviseur de rang N, et de même pas que celui du premier synthétiseur, ce rang M étant déterminé au départ pour obtenir ce même pas pour les deux synthétiseurs et que la somme de cette fréquence Fo et de cette Fréquence Fi soit égale, après passage dans le diviseur de rang N, à la fréquence de référence Fc, qui est quant-à-elle appliquée aussi bien au comparateur de phases du premier synthétiseur qu'à celui de cet autre synthétiseur.

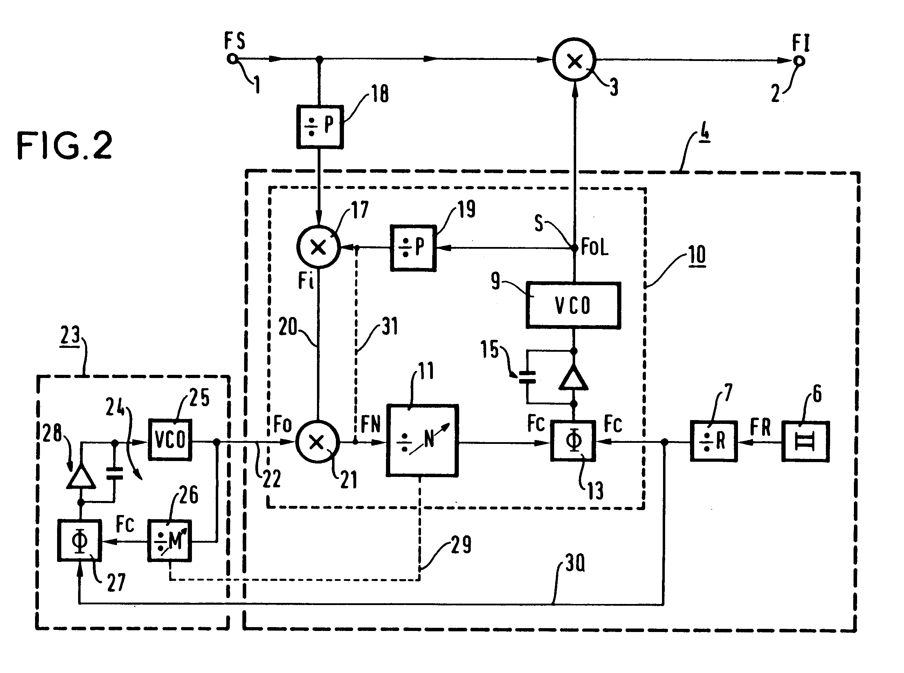

De toute façon, l'invention sera bien comprise, et ses avantages et autres caractéristiques ressortiront, lors de la description suivante d'un exemple non limitatif de réalisation de ce dispositif de transposition en Fréquence Intermédiaire, ici appliqué à un récepteur en B.I.S. de télévision par satellite, en référence à la Figure 2 jointe qui en est un schéma électrique synoptique et simplifié.

En se reportant à cette figure 2, ce dispositif de trensposition en Fréquence Intermédiaire FI se différentie de celui selon la figure 1 en ce que:
- le diviseur 11 est un diviseur de rang N variable par unités définissant pour ce synthétiseur un pas donc égal à Fc.P;
- un mélangeur additionneur de fréquences 21 est intercalé dans la liaison 20 qui relie le mélangeur soustracteur précité 17 au diviseur de rang N 11.

Cet additionneur 21 recoit sur son autre entrée 22 un signal auxiliaire qui est élaboré par un synthétiseur auxiliaire 23, comprenant lui-aussi une boucle à verrouillage de phase 24, avec VCO 25, diviseur à rang M variable 26, comparateur de phase 27, circuit d'amplification-filtrage 28. Par une liaison représentée symboliquement en 29, le diviseur 26 est incrémenté ou décrémenté en même temps que le diviseur 11 et de la même quantité.

Afin d'avoir le même pas pour les deux synthétiseurs 4 et 23, le synthétiseur auxiliaire 23 utilise, via la liaison 30, la même référence de fréquence Fc que le synthétiseur principal. Par ailleurs, le nombre M initial est ajusté au départ non seulement pour obtenir ces deux pas identiques, mais encore il définit pour le synthétiseur 23 une fréquence de sortie Fo telle qu'additionnée dans le circuit 21 avec la fréquence fixe Fi précitée, elle fournit à l'entrée du diviseur 11 un signal dont la fréquence FN est égale à la fréquence de référence Fc multipliée par le nombre N.

Cette fréquence du synthétiseur 23 est en fait égale, en régime établi, à FS/P, de sorte qu'il est avantageusement possible d'utiliser ce dispositif de transposition sans Commande Automatique de Fréquence, en réalisant simplement la liaison de court-circuitage figurée en pointillés 31.

Le synthétiseur 23 étant de même pas que le synthétiseur 4, on comprend aisément que toute incrémentation ou décrémentation corrélatives d'une unité des diviseurs 11 et 26 fera varier Fo de la valeur d'un pas, de sorte que la fréquence FN pourra aussi varier de la valeur qui correspond à un pas du synthétiseur 4.

A titre d'exemple numérique, pour un Oscillateur Local dont la fréquence doit varier, par pas de 500 KHz, de 1400 MHz à 2300 MHz, cette variation est possible en changeant le rang de division N de 2800 à 4600. Pour une fréquence FS reçue de 1235 MHz, le rang N est de 3370 pour une référence Fc de 1,953 KHz, et la fréquence FOL est alors de 1685 MHz. Le rang M est alors égal à 2470, et la fréquence Fo est de 4,824 MHz.

Comme il va de soi, l'invention n'est pas limitée à l'exemple de réalisation qui vient d'être décrit, et bien d'autres formes et variantes d'exécution de ce dispositif de transposition de fréquence avec Commande Automatique de Fréquence sont envisageables.

## Revendications

1. Dispositif de transposition de fréquence d'un signal d'entrée de fréquence FS, typiquement de transposition en Fréquence Intermédiaire FI, ce dispositif comportant un Oscillateur Local constitué par un premier synthétiseur (4) asservi sur une fréquence de référence Fc par une boucle à verrouillage de phase (10) comportant un diviseur de rang N, des moyens (18,19,17) étant prévus pour introduire dans la boucle de phase (10) de ce synthétiseur (4) un signal différentiel Fi dont la fréquence est proportionelle à la différence des fréquences incidente FS et d'Oscillateur Local FOL de manière à réaliser ainsi une Commande Automatique de Fréquence,
caractérisé en ce que, afin de pouvoir utiliser un diviseur (11) de rang N variable par unités pour pouvoir traiter plusieurs fréquences d'entrée FS différentes, il est en outre prévu d'intercaler dans cette boucle de phase (10), entre le point (20) d'introduction dans cette boucle (10) dudit signal différentiel Fi et ce diviseur (11) de rang N, un dispositif (21) apte à réaliser l'addition en fréquences de ce signal différentiel Fi et d'un autre signal de fréquence Fo qui est élaboré par un autre synthétiseur (23) comportant une autre boucle à verrouillage de phase (24) à diviseur (26) de rang variable M, ce dernier variant à chaque fois dans le même sens que l'autre diviseur de rang N, et de même pas que celui du premier synthétiseur, ce rang M étant déterminé au départ pour obtenir ce même pas pour les deux synthétiseurs et que la somme de cette fréquence Fo et de cette Fréquence Fi soit égale, après passage dans le diviseur (11) de rang N, à la fréquence de référence Fc, qui est quant-à-elle appliquée (30) aussi bien au comparateur de phases du premier synthétiseur qu'à celui de cet autre synthétiseur.

2. Dispositif selon la revendication 1, caractérisé en ce que, lesdits moyens comportant des diviseurs (18,19) de même rang P aux deux entrées d'un soustracteur en fréquences (17), et la fréquence Fo de cet autre synthétiseur (23) étant alors égale, en régime établi, à la fréquence reçue FS divisée par ce rang P, des moyens de court-circuitage (31) sont prévus afin de permettre au dispositif de fonctionner immédiatement sans Commande Automatique de Fréquence.

## Patentansprüche

1. Einrichtung zum Umsetzen der Frequenz eines Eingangssignals mit der Frequenz FS, insbesondere zum Umsetzen in den Zwischenfrequenzbereich ZF, wobei die Einrichtung einen örtlichen Oszillator aufweist, der aus einem ersten Synthetisierer (4) besteht, der auf eine Bezugsfrequenz Fc durch eine Phasenverriegelungsschleife (10) geregelt wird, die einen Teiler des Rangs N aufweist, wobei Mittel (18, 19, 17) zum Eingeben eines Differenzsignals Fi in die Phasenschleife des Synthetisierers (4) vorgesehen sind, dessen Frequenz zur Differenz der ankommenden Frequenz FS und der Frequenz des örtlichen Oszillators FOL proportional ist, derart, daß so eine automatische Frequenzregelung geschaffen wird,
dadurch gekennzeichnet, daß, um einen Teiler (11) mit um ganze Einheiten veränderlichem Rang N zur Verarbeitung mehrerer unterschiedlicher Eingangsfrequenzen FS benutzen zu können, weiter in diese Phasenschleife (10) zwischen den Eingabepunkt des Differenzsignals Fi in die Schleife (10) und den Teiler (11) des Rangs N eine Einrichtung (21) eingefügt ist, die die Frequenzen dieses Differenzsignals Fi und eines weiteren Signals mit der Frequenz Fo addieren kann, das von einem anderen Synthetisierer (23) erzeugt wird, der eine andere Phasenverriegelungsschleife (24) mit einem Teiler (26) des veränderlichen Rangs M aufweist, wobei sich dieser Rang jedesmal in gleicher Richtung wie der andere Rang N und mit der gleichen Schrittweite wie der erste Synthetisierer ändert und der Rang M zu Anfang festgelegt wird, um die gleiche Schrittweite für die beiden Synthetisierer zu erzielen und damit die Summe dieser Frequenz Fo und dieser Frequenz Fi nach dem Durchgang durch den Teiler (11) des Rangs N der Bezugsfrequenz Fc entspricht, die ihrerseits sowohl an den Phasenkomparator des ersten Synthetisierers als auch an den des anderen Synthetisierers angelegt (30) wird.

2. Einrichtung nach Anspruch 1, dadurch gekennzeichnet, daß die Mittel Teiler (18, 19) mit dem gleichen Rang P an zwei Eingängen eines Frequenzsubtrahierers (17) umfassen und die Frequenz Fo des anderen Synthetisierers (23) dann im Betrieb der empfangenen und durch den Rang P geteilten Frequenz FS entspricht und daß Kurzschlußmittel (31) vorgesehen sind, um der Einrichtung das sofortige Funktionieren ohne automatische Frequenzregelung zu ermöglichen.

## Claims

1. Device for converting the frequency FS of an input signal, typically an intermediate frequency converter device consisting of a first synthesizer (4) slaved to a reference frequency Fc by a phase-locked loop (10) including a divider by N, means (18, 19, 17) being provided for introducing into the phase-locked loop (10) of the synthesizer (4) a differential signal Fi whose frequency is proportional to the difference between the incoming frequency FS and the local oscillator frequency FoL so as to achieve automatic frequency control,
characterised in that, in order to enable use of a divider (11) which divides by a factor N that can be varied one unit at a time in order to process a plurality of input frequencies FS, there is further provision for inserting into the phase-locked loop (10), between the point (20) at which said differential signal Fi is introduced into the loop (10) and the divider (11) by N, a device (21) adapted to sum the frequency of the difference signal Fi and another signal of frequency Fo produced by another synthesizer (23) including another phase-locked loop (24) with a divider (26) dividing by a variable factor M, varying each time in the same sense as N and by the same increment as the first synthesizer, the value M being defined at the outset to obtain the same increment for both synthesizers, and in that the frequency Fo and the frequency Fi are equal, after passing through the divider (11) by N, to the reference frequency Ft which is applied (30) to the phase comparator of the first synthesizer and to that of the other synthesizer.

2. Device according to claim 1 characterised in that, said means comprising dividers (18, 19) with the same dividing factor P at both inputs of a mixer (17) and the frequency Fo of the other synthesizer (23) being then equal under steady state conditions to the received frequency FS divided by P, short-circuit means (31) are provided to enable the device to operate immediately without automatic frequency control.
